# EUROPEAN PATENT APPLICATION

(11) **EP 1 520 945 A2**
(43) Date of publication of application: **06.04.2005**
(21) Application number: 04021877.8
(22) Date of filing: 15.09.2004
(51) Int. Cl.: E04B 1/80, D04H 13/00

(54) **Mineral fibre based insulating panel and related production method**

(30) Priority: 30.09.2003 IT MI20031877
(71) Applicant: SAINT-GOBAIN ISOVER ITALIA S.P.A., 20146 Milano (IT)
(72) Inventor: Ferri, Enrico, 24047 Treviglio (BG) (IT); Mazzoleni, Sergio, 24124 Bergamo (IT); Valota, Franco, 24050 Bariano (IT)
(74) Representative: Petruzziello, Aldo

(57) **Abstract**

An insulating panel based on mineral fibres, in particular glass fibres, and a production method for said panel are described. The panel comprises a core (13; 113) of interlinked mineral fibres and a layer of coating (9, 9') applied on at least one side of the core of mineral fibres (13; 113). The layer of coating (9; 9') comprises a nonwoven fabric or a glass fabric or a glass film.

## Description

The present invention concerns an insulating panel based on mineral fibres such as glass fibres, glass wool, rock wool and similar and a production method for said insulating panel. For the sake of simplicity in this document we shall talk mainly about glass fibre panels.

They are very common on the market of heat insulation panels generally used for insulating electrical household appliances such as electric or microwave ovens, refrigerators, boilers, conditioners and similar.

Said panels contain a core of insulating material, such as glass fibres, which can be coated on one or both sides with a film of aluminium. The aluminium coating layer is applied to improve handling of the panels, to contain the dust produced by the glass fibres, to reduce the risks of fraying of the glass fibres and prevent sticking together when the panels are superimposed or stacked.

Said panels are generally positioned on the outside of the compartment containing the electrical appliance, with the aluminium coating of the panel generally positioned on the side of the panel facing the outside of the appliance. Generally said panels are not exposed, but positioned in an air space formed in the casing of the appliance.

Before assembly on the appliance, said panels are generally preformed with appropriate holes to house the fixing devices and to permit, for example, the passage of electrical cables of the appliance.

The insulating panels according to the known technique have several drawbacks due above all to the electrical and thermal conductive characteristics of the aluminium coating layer.

In fact, since said panels are often crossed by or are in contact with electrical cables, if said electrical cables are not adequately insulated, the aluminium coating which is electrically conductive may produce dangerous short circuits. In addition, the aluminium coating is not sufficiently elastic and therefore flexible and is subjected to breakage in addition to the risk of cuts on the edges.

Furthermore, since the glass fibre core is a good thermal insulator and the aluminium coating is a good conductor of heat, a thermal head is created between the glass fibre core and the aluminium coating which negatively affects the insulating characteristics of the panel.

For the production of said panels according to the known art, initially molten glass is placed in a fiberizing machine; the glass fibres produced are mixed with a binder and fall onto a conveyor belt where air extraction is performed, after which they are conveyed to a stove in order to stabilise the binder.

Alternatively to the use of a binder to bind the glass fibres of the panel core, said fibres, piled on the conveyor belt, can undergo a needle felting process to obtain a mechanical link between them via the use of special hooked needles.

In any case a core or mat of glass fibres is obtained, linked chemically (via a binder) or mechanically (by means of needle felting), which can be wound in a roll for transport to the next work step in which the aluminium coating is glued to the glass fibre mat by means of an appropriate silicate adhesive.

Subsequently the glass fibre mat with aluminium coating is wound into rolls or cut if necessary to form semi-finished panels which are punched in order to obtain the required dimensions with appropriate holes for fixing and passage of cables.

Lastly, the rolls or panels of semi-finished product are sent to a final drying step for drying the adhesive used for application of the aluminium coating.

It is obvious that said production processes for insulating panels are lengthy and costly, above all due to the many steps involved in gluing of the aluminium coatings.

The object of the present invention is to eliminate the disadvantages of the known art, providing a glass fibre-based insulating panel, which has good insulation characteristics and at the same time ensures good electrical insulation.

A further object of the invention is to provide an insulating panel that is extremely flexible and eliminates all risks of cuts.

A further object of the present invention is to provide an insulating panel which is versatile, practical for the user, inexpensive and easy to produce.

These objects are achieved in accordance with the invention with the insulating panel having the characteristics listed in the attached independent claim 1.

A further object of the present invention is to provide a production method for a mineral fibre based insulating panel which is efficient, quick and at the same time inexpensive and simple.

This object is achieved in accordance with the invention with the production methods for an insulating panel, the steps of which are listed respectively in the attached claims 12 and 18.

The glass fibre based insulating panel according to the invention comprises a core of interlinked glass fibres and a layer of coating linked to at least one side of the core of glass fibres.

The special characteristic of the invention is represented by the fact that the layer of coating comprises a non-woven fabric or a mineral fibre fabric, or a film of mineral fibres, in particular glass fibres. For the sake of convenience the coating layer will be indicated hereafter mainly as a layer of non-woven fabric.

This provides numerous advantages both in the end product and in the production process.

In fact, non-woven fabric is a good electrical and thermal insulator. As a result the risks of short circuit of the electrical cables that cross the panel are eliminated and at the same time there is no sudden thermal head between the glass wool core and the layer of non-woven fabric coating.

Furthermore the non-woven fabric coating improves handling of the panel, giving the user a better feel than panels with aluminium coating.

Furthermore since non-woven fabric is more elastic and flexible than aluminium, in addition to improving handling of the panel, the risks of breakage at the edges of the panel are eliminated.

Further characteristics of the invention will be more apparent from the detailed description that follows referring to the purely illustrative and therefore non-restrictive embodiments shown in the attached drawings, in which:
Fig. 1 is a block diagram schematically illustrating the production process of a mineral fibre based insulating panel according to the invention; and
Fig. 2 is a block diagram schematically illustrating a second embodiment of the production process of a mineral fibre based insulating panel.

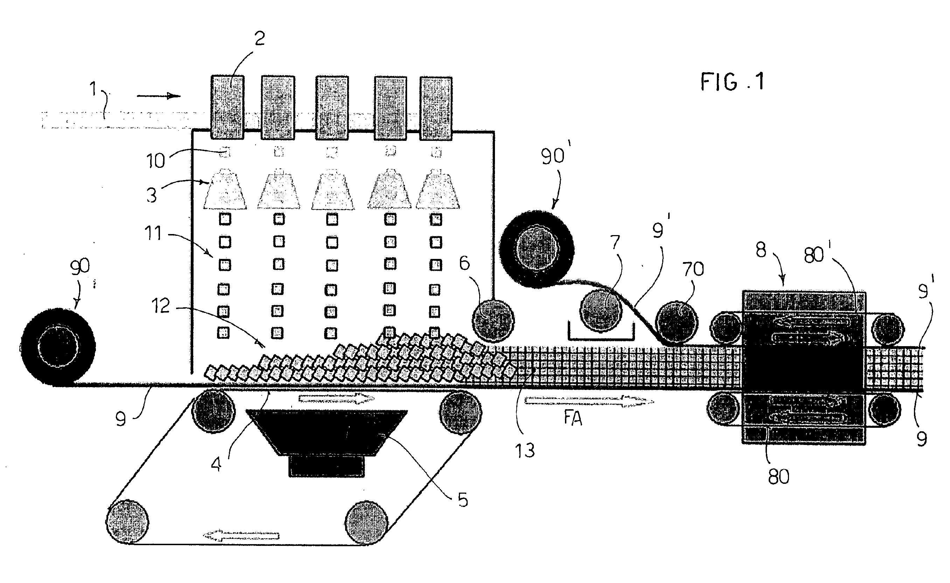

With the help of Fig. 1, a first embodiment of the glass fibre-based insulating panel production process, according to the invention, is now described.

A mass of molten glass 1 is conveyed to a glass fibre production machine 2 which produces a plurality of glass fibres 10.

The glass fibres 10 coming out of the fiberizing machine 2 are conveyed to a nebulizer device 3 from which binders are sprayed that combine with the glass fibres 10 in order to produce a chemical link between them. The binders that can be used comprise inorganic binders such as an aqueous solution of aluminium polyphosphate salts.

In this way the nebulizer device 3 produces glass fibres mixed with binders 11 which are collected on a support 9 in order to form a loose mass 12 of glass fibres and binder, in which the binder is performing its binding action on the glass fibres. The support 9 is in the form of a belt which is unwound from a master coil 90 and fed forward in the direction of the arrow F_{A} by means of a conveyor belt 4.

The support 9 is a belt made of non-woven fabric or glass fabric or glass film. The support 9 preferably consists of a non-woven fabric based on plastic materials, such as derivatives of polyethylene or polyester with the addition of heavy metal oxides.

The support 9 has a thickness in the range of from approximately 0.05 mm to 1.5 mm and a gram weight in the range of from approximately 10 g/m² to 100 g/m².

In the area of the conveyor belt 4, below the support 9, an extraction unit 5 is provided which has the function of extracting air from the loose mass 12 of glass fibres and binder, via the support 9, in order to extract the dust from the glass fibres and at the same time favour an initial reduction in the humidity of the fibre and the binders.

It should be noted that, thanks to the use of a non-woven fabric support 9 with gram weight appropriate for filtering the air, the air extraction step can be performed simultaneously with receipt of the mass of glass fibres 12 on the support 9. This operation is clearly impossible if a metal material is used as a support 9, such as an aluminium film, as in the known art, which does not permit the passage of air.

Downstream of the extractor 5, above the mass of glass fibres 12, a pressure roller 6 is positioned which has the function of performing a first compacting of the glass fibres in order to obtain a substantially uniform core or mat of glass fibres 13 arranged on the support 9. Adhesion of the lower support 9 to the mat of glass fibres 13 is guaranteed by the extraction step performed by the extractor 5, during which the humidity of the binder is reduced.

To obtain an end product consisting of a glass fibre panel with coating on both sides, a second master coil 90' is used from which a non-woven fabric strip 9' is unwound, substantially the same as the coating 9 unwound from the first master coil 90.

Downstream of the pressure roller 6, above the compact glass fibre mat 13, an inkapplicator unit 7 is positioned comprising a binder distributor roller which takes the binder from a basin below and spreads it on the lower surface of the strip of non-woven fabric 9'. The binder used in this step can be the same as the one used in the nebulizer device 3, but in different aqueous solutions.

The need to use the applicator unit 7 is due to the fact that downstream of the extractor 5 the binder added to the glass fibres during the spray step has completely dried and is therefore unable to guarantee adhesion of the upper support on the glass fibre mat 13. Downstream of the applicator unit 7 a pressure roller 70 is provided which ensures coupling of the support 9' with the fibre mat 13.

To ensure adhesion of the upper support 9' on the glass fibre mat 13, the glass fibre mat 13, compressed in a sandwich between the lower support 9 and the upper support 9', is fed, by means of a lower conveyor belt 80 and an upper conveyor belt 80', into a stove 8 which dries the binder deposited by the applicator unit 7 and therefore ensures adhesion of the upper support 9' on the glass fibre mat 13 and stabilisation of the adhesive between the fibres. The working temperature of the stove 8 for drying the binder is between 100°C and 200°C.

Finally, the layer of glass fibres 13 with the lower and upper supports attached 9, 9' is collected in a roll or is directly cut and punched in order to obtain insulating felts, of appropriate dimensions, consisting of a layer of glass fibres 13 bound together and bound to at least one support 9, 9' by means of inorganic type binders.

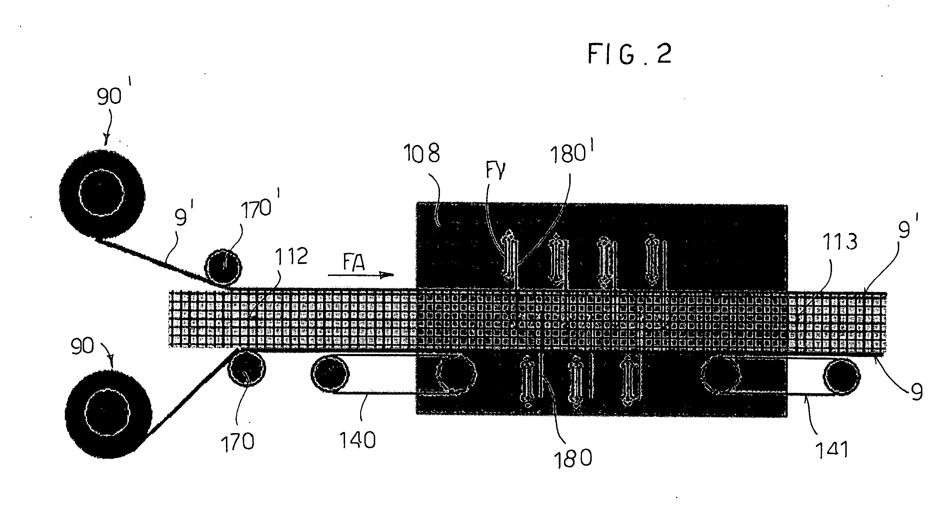

Fig. 2 describes a second embodiment of the production process of a glass fibre-based insulating panel, which is configured as a variation of the process of Fig. 1. In this second embodiment, therefore, elements equal or corresponding to those already described with reference to Fig. 1 are indicated with the same reference numbers and their detailed description is omitted.

In this second embodiment, the glass fibres 10 produced by the fiberizing machine 2 are not mixed with binders designed to create a chemical bond between the fibres. In this case a minimum quantity of binder is used solely for the purpose of dust prevention and not for the creation of a chemical bond between the fibres. Generally a type of binder known under the name Fomblin® is used as dust prevention binder.

At this point the glass fibres are massed together to form a mat 112 (Fig. 2) which can be wound in a roll.

The glass fibre mat 112 is fed between two supports 9, 9' unwound from a first and a second master coil 90, 90'. Clearly, if coating is required only on one side of the fibres, one of the two coils 90, 90', preferably the upper one 90', can be omitted.

Downstream of the coils 90, 90' respective coupling rollers 170, 170' are provided designed to lay the respective supports 9, 9' below and above the glass fibre mat 112. The glass fibre mat 112 with the respective supports 9, 9' is fed, via a conveyor belt 140, in the direction of the arrow F_{A}, towards a needle felting machine 108.

The needle felting machine 108 comprises a plurality of hooked needles 180 arranged below the surface of the lower support 9 and a plurality of hooked needles 180' arranged above the surface of the upper support 9'. The lower needles 180 and the upper needles 180' move vertically, by alternating movement, according to the direction of the arrows F_{V}.

In this way the needles 180, 180' cross the respective supports 9, 9' and link the glass fibres of the mat 112 to each other and to the respective supports 9, 9'. The result at the outlet of the needle felting machine 108 is a mat or core of compact glass fibres 113 in which the glass fibres are linked mechanically to each other and to the respective lower and upper supports 9, 9'.

It should be noted that, thanks to the use of a support 9, 9' made of non-woven fabric with a gram weight that allows the needles 180, 180' to pass through it, the needle felting phase can be performed directly on the supports 9, 9' thus avoiding the further phase of gluing the supports 9, 9' on the fibre mat 112. Said operation is clearly impossible if a metal material is used as support 9, 9', such as an aluminium film, as in the known art, which would be pierced by the passage of the needles 180, 180'.

Said fibre mat 113 with the respective supports 9, 9' linked mechanically is conveyed out of the needle felting machine 108 by means of a conveyor 141 and sent to the subsequent steps in which it is wound on rolls and then cut and/or punched in order to obtain the required products.

Numerous detail variations and modifications can be made to the present embodiments of the invention within the capability of a person skilled in the art, all falling within the field of the invention expressed by the attached claims.

## Claims

1. Insulating panel based on mineral fibres, such as glass fibres, glass wool, rock wool and similar, comprising a core (13; 113) of mineral fibres linked to each other and a layer of coating (9, 9') applied on at least one side of said core of mineral fibres (13; 113), **characterised in that** said layer of coating (9; 9') comprises a non-woven fabric or a mineral fibre fabric or a mineral fibre film.

2. Panel according to claim 1, **characterised in that** said mineral fibres of said coating layer (9, 9') are glass fibres.

3. Panel according to claim 1, **characterised in that** said coating layer (9; 9') comprises a non-woven fabric consisting of derivatives of polyethylene or polyester with the addition of heavy metal oxides.

4. Panel according to any one of the previous claims, **characterised in that** said coating layer (9; 9') has a thickness in the range of from 0.05 mm to 1.5 mm.

5. Panel according to any one of the previous claims, **characterised in that** said coating layer (9; 9') has a gram weight in the range of from 10 g/m² to 100 g/m².

6. Panel according to any one of the previous claims, **characterised in that** it comprises chemical binders to permit both a chemical link between the mineral fibres of the core (13) and a chemical link between the coating layer (9; 9') and the mineral fibres of the core (13).

7. Panel according to claim 6, **characterised in that** said chemical binder is an inorganic binder consisting of an aqueous solution of polyphosphate aluminium salts.

8. Panel according to any one of the claims from 1 to 5, **characterised in that** said mineral fibres of the core (113) are mechanically interlinked and that said layer of coating (9, 9') is mechanically linked to the mineral fibres of the core (113).

9. Panel according to claim 8, **characterised in that** said mechanical link is obtained by needle felting of the mineral fibres to each other and by needle felting of the mineral fibres to the coating layer (9, 9').

10. Panel according to claims 8 or 9, **characterised in that** it comprises a dust-prevention binder between the mineral fibres of the core (113).

11. Panel according to claim 9, **characterised in that** said dust-prevention binder is Fomblin®.

12. Method for the production of a mineral fibre based insulating panel according to any one of the claims from 1 to 7, comprising the following steps:
- obtaining of mineral fibres (10) from a molten mineral substance (1);
- chemical binding of said mineral fibres (10) in order to obtain a core of chemically linked mineral fibres (13; 113);
- chemical binding of said core of mineral fibres (13; 113) to a layer of coating (9, 9') positioned on at least one side of said core of mineral fibres (13; 113).

13. Method according to claim 12, **characterised in that** said binding of the mineral fibres (13; 113) to each other is performed simultaneously with binding of the mineral fibres to the layer of coating (9, 9'), via chemical type binding.

14. Method according to claims 12 or 13, **characterised in that** said chemical binding steps comprise the following phases:
- addition of inorganic binders to the mineral fibres (10);
- collection of the mineral fibres (11) with the inorganic binders on a strip of said coating layer (9);
- extraction of air, via said coating layer (9), and subsequent drying of said inorganic binders to bind the mineral fibres to each other and to the coating layer (9).

15. Method according to claim 14, **characterised in that** it furthermore comprises the following steps:
- deposit of inorganic binder on a second coating layer (9'); and
- application of said second coating layer (9') on the side of the mineral fibre core (13) opposite the one where said first coating layer (9) is attached, so that said inorganic binder is located between said second coating layer (9') and one side of the glass fibre core (13).

16. Method according to claim 15, **characterised in that** it comprises furthermore the step of drying said inorganic binder deposited between said second coating layer (9') and one side of the glass fibre core (13), by means of heating.

17. Method according to claim 16, **characterised in that** said drying of the inorganic binder, by heating, is performed at a temperature of between 100°C and 200°C.

18. Method for the production of a mineral fibre based insulating panel, according to any one of the claims from 8 to 11, comprising the following steps:
- obtaining of mineral fibres (10) from a molten mineral substance (1);
- mechanical binding of said mineral fibres (10) in order to obtain a core of mechanically linked mineral fibres (113);
- mechanical binding of said core of mineral fibres (113) to a coating layer (9, 9') positioned on at least one side of said core of mineral fibres (113).

19. Method according to claim 18, **characterised in that** said binding of the mineral fibres (113) to each other is performed simultaneously with binding of the mineral fibres to the coating layer (9, 9'), by means of mechanical type binding.

20. Method according to claims 18 or 19, **characterised in that** said mechanical binding is performed by means of needle felting, in which hooked needles (180, 180') cross said coating layer (9, 9') to mechanically bind the mineral fibres of the core (113) to each other and to the layer of coating (9, 9').

21. Method according to any one of the claims from 18 to 20, **characterised in that** it comprises the step of adding dust-prevention binders to the mineral fibres, before the mechanical binding step.
